(19) Europäisches Patentamt
European Patent Office
Office européen des brevets

(11) EP 1 561 597 A2

(12) # EUROPEAN PATENT APPLICATION

(43) Date of publication:
**10.08.2005 Bulletin 2005/32**

(51) Int Cl.[7]: **B41N 1/14**, B41C 1/10

(21) Application number: **05100561.9**

(22) Date of filing: **28.01.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **06.02.2004 JP 2004030375**

(71) Applicant: **Konica Minolta Medical & Graphic, Inc.**
**Tokyo 163-0512 (JP)**
Designated Contracting States:
**DE FR GB**

(72) Inventor: **Sampei, Takeshi**
**Konica Minolta Med.& Graphic, Inc.**
**192-8505 Tokyo (JP)**

(74) Representative:
**Gille, Struck, Neidlein, Prop, Roos**
**Patentanwälte**
**Brucknerstrasse 20**
**40593 Düsseldorf (DE)**

(54) **Planographic printing plate material, printing plate and printing method**

(57) An object of the invention is to provide a planographic printing plate material providing excellent initial ink receptivity, excellent printing durability and greatly improved registering property, a printing plate prepared therefrom, and a printing method employing the printing plate. The forgoing printing plate material comprising a hydrophilic layer on one surface and a backing layer on the other surface of a plastic sheet support, wherein the backing layer contains an organic matting agent and a polymer having a glass transition temperature (Tg) of -30 to 40 °C is used to attain the object.

EP 1 561 597 A2

## Description

### TECHNICAL FIELD

The present invention relates to a planographic printing plate material, a printing plate and a printing method employing the planographic printing plate material.

### BACKGROUND

In recent years, a computer to plate system (CTP), in which an image data can be directly recorded in a printing plate material, has been widely used accompanied with the digitization of printing data. As a printing plate material usable for CTP, there are a printing plate material comprising an aluminum support such as a conventional PS plate, and a flexible printing plate material comprising a flexible resin film sheet and provided thereon, various functional layers.

Recently, in commercial printing industries, there is a tendency that many kinds of prints are printed in a small amount, and a printing plate material with high quality, which is inexpensive, has been required in the market. As a conventional flexible printing plate material, there are a silver salt diffusion transfer type printing plate material as disclosed in Japanese Patent O.P.I. Publication No. 5-66564, in which a silver salt diffusion transfer type light sensitive layer is provided on a flexible sheet, an ablation type printing plate material as disclosed in Japanese Patent O.P.I. Publication Nos. 8-507727, 6-186750, 6-199064, 7-314934, 10-58636 and 10-244773 in which a hydrophilic layer and a lipophilic layer, one of which is an outermost layer, are provided on a flexible sheet where the outermost layer is ablated by laser exposure to prepare a printing plate, and a heat melt type printing plate material as disclosed in Japanese Patent O.P.I. Publication No. 2001-96710 in which a hydrophilic layer and a heat melt image formation layer are provided on a flexible sheet where a hydrophilic layer or a heat melt image formation layer is imagewise heated by laser exposure to heat and fix the image formation layer onto the hydrophilic layer.

The silver salt diffusion transfer type printing plate material requires a wet development step and a drying step after exposure, which does not give sufficient dimensional accuracy during the image formation step. The ablation type printing plate material does not require a wet development step, but image formation due to ablation is likely to fluctuate in dot shape. Further, there is problem in which the interior of the exposing apparatus or the printing plate surface is contaminated by scattered matters caused by ablation of the layer. The heat melt type printing plate material in which the heat melt image formation layer is fixed onto the hydrophilic layer, after image formation, is mounted on an off-set press. When on printing, a dampening water is supplied to the printing plate material, only the image formation layer at non-image portions is swollen or dissolved by the dampening water, and transferred to a printing paper (paper waste) to remove. Accordingly, a special development step is not required, and image formation due to heat melt provides a sharp dot shape, and prints with high image quality.

When laser exposure is carried out, a flexible printing plate material is generally fixed on a specific position of a flat or curved fixing member of an exposure device, and exposed. As methods of fixing a printing plate material on a fixing member, there are a vacuum fixing method in which a printing plate material is fixed on a fixing member with suction holes under atmospheric pressure, by evacuating air between the plate and the fixing member through the suction holes, a magnetically fixing method in which a printing plate material is fixed on a fixing member with a ferromagnetic surface by magnetic force, and a clamping method in which a printing plate material fixed on a fixing member by mechanically clamping the both edges thereof by clamps.

A printing plate material and a printing plate prepared therefrom according to a silver salt diffusion transfer method are well known, the printing plate material comprising a hydrophilic layer, a silver halide emulsion layer, a physical developing nucleus-containing layer, and a backing layer.

Recently, as color printing spreads, a printing plate material suitable for color printing has been required.
Since plural printing plates are employed in the color printing, a printing plate with so-called high register accuracy has been required which does not cause "out of color registration" during printing.

As substrates of the planographic printing plate material above for CTP, various ones are known. A printing plate material employing as the substrate a plastic film sheet has been developed in that it is easy to handle and carry (see for example, patent documents 1, 2, and 3).

However, a planographic printing plate material employing as a support a plastic film sheet has problems in that printing durability after long term storage and initial ink receptivity are poor, and "out of color registration" during printing, so called "out of register", is likely to be caused. A planographic printing plate material solving these problems has eagerly been desired. The printing plate material according to a silver salt diffusion transfer method comprising a hydrophilic layer, a silver halide emulsion layer, a physical developing nucleus-containing layer, and a backing layer has those problems especially.

(Patent document 1) Japanese Patent O.P.I. Publication No. 4-261539
(Patent document 2) Japanese Patent O.P.I. Publication No. 5-257287
(Patent document 3) Japanese Patent O.P.I. Publication No. 2000-258899

## SUMMARY

The present invention has been made to solve the above problems. Accordingly, an object of the invention is to provide a planographic printing plate material which is improved in printing durability after long term storage, initial ink receptivity, and registering property during printing, to provide a printing plate prepared therefrom, and to provide a printing method employing the printing plate.

## DESCRIPTION OF THE PREFERRED EMBODIMENTS

The above object has been attained by one of the following structures:

(Structure 1) A planographic printing plate material possessing a plastic support having a hydrophilic layer on one surface and a backing layer on the other surface of the plastic support, wherein the backing layer contains an organic matting agent and a polymer having a glass transition temperature (Tg) of -30 to 40 °C.
(Structure 2) The planographic printing plate material of Structure 1, wherein the backing layer has a specific resistance of $1 \times 10^9$ to $2 \times 10^{13}$ Ω.
(Structure 3) The planographic printing plate material of Structure 1, including a silver halide emulsion layer and a physical developing nucleus-containing layer on the hydrophilic layer.
(Structure 4) The planographic printing plate material of Structure 2, further comprising the silver halide emulsion layer and the physical developing nucleus-containing layer on the hydrophilic layer.
(Structure 5) The planographic printing plate material of Structure 1, wherein the plastic support has an average thickness of 110 to 300 μm.
(Structure 6) The planographic printing plate material of Structure 2, wherein the plastic support has the average thickness of 110 to 300 μm.
(Structure 7) The planographic printing plate material of Structure 3, wherein the plastic support has the average thickness of 110 to 300 μm.
(Structure 8) The planographic printing plate material of Structure 1, wherein the planographic printing plate material is wound around a core having a diameter of 4 to 10 cm so as to form a roll.
(Structure 9) The planographic printing plate material of Structure 2, wherein the planographic printing plate material is wound around the core having a diameter of 4 to 10 cm so as to form a roll.
(Structure 10) The planographic printing plate material of Structure 3, wherein the planographic printing plate material is wound around the core having a diameter of 4 to 10 cm so as to form a roll.
(Structure 11) The planographic printing plate material of Structure 5, wherein the planographic printing plate material is wound around the core having a diameter of 4 to 10 cm so as to form a roll.
(Structure 12) A printing plate obtained by imagewise exposing a surface of the hydrophilic layer of the planographic printing plate material of Structure 1 to laser beams based on image data and developing the exposured planographic printing plate material.
(Structure 13) The printing plate obtained by imagewise exposing a surface of the hydrophilic layer of the planographic printing plate material of Structure 2 to laser beams based on image data and developing the exposed planographic printing plate material.
(Structure 14) The printing plate obtained by imagewise exposing a surface of the hydrophilic layer of the planographic printing plate material of Structure 3 to laser beams based on image data and developing the exposed planographic printing plate material.
(Structure 15) The printing plate obtained by imagewise exposing a surface of the hydrophilic layer of the planographic printing plate material of Structure 5 to laser beams based on image and developing the exposed planographic printing plate material.
(Structure 16) The printing plate obtained by imagewise exposing a surface of the hydrophilic layer of the planographic printing plate material of Structure 8 to laser beams based on image data and developing the planographic printing plate material.
(Structure 17) A printing method having the steps of providing a plurality of through-holes in the printing plate of Structure 12 and fixing the printing plate on a plate cylinder of a printing press, so that the through-holes coincide with a standard position for positioning.

## DETAILED DESCRIPTION OF THE INVENTION

The present invention will be explained in detail below.

A planographic printing plate material in the present invention has a layer on a plastic sheet support by which a printable image can be formed after exposure or a development step. There are preferably a planographic printing plate material employing a silver salt diffusion transfer method described in Japanese Patent O.P.I. Publication No. 4-261539, or an ablation type based on a thermal laser recording or a thermal head recording described in Japanese Patent O.P.I. Publication Nos. 8-507727 and 6-186750, planographic printing plate materials of a thermal adhesiveness image layer desktop development type and a thermofusible transfer type described in Japanese Patent O.P.I. Publication Nos. 9-123387 and 2002-361996. The present invention among those has a profound effect on the planographic printing plate material according to a silver salt diffusion transfer method comprising a hydrophilic layer, a silver halide emulsion layer, a physical developing nucleus-containing layer, and a backing layer.

The planographic printing plate material in the present invention has a hydrophilic layer on one surface and a backing layer on the other surface of a plastic sheet support and the backing layer contains polymer with -30 to 40 °C (preferably -20 to 30 °C ) in glass transition temperature Tg and an organic matting agent. It is further preferable that there are present a silver halide emulsion layer and a physical developing nucleus-containing layer on the foregoing hydrophilic layer side.

It is found that excellent properties such as initial ink receptivity and printing durability of a printing plate prepared with the planographic printing plate material are obtained, and "out of color registration" during printing (out of register) is also improved when a backing layer of the planographic printing plate material has polymer and an organic matting agent as specified above.

It can be seen in the present invention that at least one backing layer which is one of the constituent layers with the planographic printing plate material contains polymer with -30 to 40 °C (preferably -20 to 30 °C ) in glass transition temperature Tg. In the case of backing layers present with two layers or more according to the present invention, it is especially preferred that polymer described in the present invention is contained in an outermost layer.

The polymer used in this invention refers preferably to polymer latex in a dispersion in which the water-insoluble hydrophobic polymer is dispersed in a water-soluble dispersion medium, in the form of minute particles. Dispersion states may be any of the following states: the polymer is emulsified in a dispersion medium in a dispersed state; the polymer is formed employing emulsion polymerization; the polymer is subjected to micelle dispersion; or the polymer has a partial hydrophilic structure in the molecule, and the molecular chain itself is subjected to molecular dispersion. Polymer latexes are described for example in, "Gosei Jushi Emulsion (Synthetic Resin Emulsion)", edited by Taira Okuda and Hiroshi Inagaki, published by Kobunshi Kankokai (1978); "Gosei Latex no Oyo (Application of Synthetic Latexes)", edited by Takaaki Sugimura, Yasuo Kataoka, Soichi Suzuki, and Keiji Kasahara, published by Kobunshi Kankokai (1993); and Soichi Muroi, and "Gosei Latex no Kagaku (Chemistry of Synthetic Latexes)", published by Kobunshi Kankokai (1970).

The mean particle size of dispersing particles is 1 to 50000 nm, and more preferably 5 to 1000 nm. The particle size distribution thereof is not specifically limited and may be a polydispersed or a monodispersed distribution. The polymer latexes used in the invention may be those having a uniform structure as well as core/shell type latexes. In this case, it is sometimes preferred that the glass transition temperature Tg is different between the core and shell.

The glass transition temperature Tg of polymer used in the present invention is in the range between -30 and 40 °C. The minimum forming (tarnishing) temperature (MFT) of the polymer latexes is preferably -30 to 90° C, and more preferably 0 to 70° C. A tarnishing aid is also called a plasticizer, which is an organic compound (conventionally, an organic solvent) capable of lowering the MFT of a polymer latex and described in "Chemistry of Synthetic Latex" (S. Muroi, published by KOBUNSHI-KANKOKAI, 1970).

Polymers used for polymer latexes in the present invention include acryl resin, vinyl acetate resin, polyester resin, polyurethane resin, rubber type resin, vinyl chloride resin, vinylidene chloride resin, polyolefin resin and their copolymers. Polymers may be a straight-chained polymer or branched polymer, or a cross-linked polymer, including homopolymers and copolymers. The copolymer may be a random copolymer or a block copolymer. The number-averaged molecular weight of the copolymer is preferably 5,000 to 1,000,000, and more preferably 10,000 to 100,000. In the case of a molecular weight in this range, good results can be obtained in mechanical strength of a layer and film forming property.

Exemplary examples of polymer latexes in the present invention include a latex of methylmethacrylate/ethylmethacrylate/methacrylic acid copolymer, a latex of methylmethacrylate/2-ethylhexylacrylate/styrene/acrylic acid copolymer, a latex of styrene/butadiene/acrylic acid copolymer, a latex of styrene/butadiene/divinylbenzene/methacrylic acid copolymer, a latex of methylmethacrylate/vinyl chloride/acrylic acid copolymer, and a latex of vinylidene chloride/ethylacrylate/acrylonitrile/methacrylic acid copolymer. Examples of commercially available acryl resin include Sevian A-4635, 46583, and 4601 (available from DAISEL CHEMICAL Ind. Ltd.)Nipol Lx811, 814, 821, 820, and 857 (available from NIHON ZEON Co. Ltd. Examples of polyester rein include FINETEX ES650, 611, 675, 850 (available from DAINIPPON INK CHEMICAL Co. Ltd.), and WD-size WMS (available from Eastman Kodak Corp.). Examples of polyurethane resin include HYDRAN AP10, 20, 30, 40 (available from DAINIPPON INK CHEMICAL Co. Ltd.). Examples of rubber resin include LACSTAR 7310K, 3307, 4700H, 7132C (available from DAINIPPON INK CHEMICAL Co. Ltd.); and Nipol Lx416, 410, 438C and 2507 (available from NIHON ZEON Co. Ltd.). Examples of vinylidene chloride resin include L502, L513 (available from ASAHI CHEMICAL IND. Co. Ltd.), ARON D7020, D504, and D5071 (available from MITSUI TOATSU CHEMICALS, INC.).
Commercially available examples of olefin resin include CHEMIPAL S120, SA100 (available from MITSUI PETROLEUM CHEMICAL IND. Co. Ltd.).

These polymers can be used alone or may be blended. It is also preferable that the content of polymer used in the present invention is 50 wt% or more.

Though in the present invention, both water and organic solvent can be allowed to use as a solvent used in the coating solution for a backing layer containing the foregoing polymer, the coating solution in which preferably at least 60% by weight of a solvent is water should be used. The solvent(s) contained in the coating solution other than water include, for example, water-miscible organic solvents, such as methanol, ethanol, isopropanol, methyl cellosolve, ethyl cellosolve, dimethyl formamide and ethyl acetate. Examples of the solvent composition include water (100), water/methanol (90/10), water/methanol (70/30), water/ethanol (90/10), water/isopropanol (90/10), water/dimethyl formamide (95/5), water/methanol/dimethyl formamide (80/15/5), and water/methanol/dimethyl formamide (90/5/5), wherein the number means weight percentage.

A water-soluble surfactant may be added for improving the coating ability of the coating liquid used in the present invention. A silicon atom-containing surfactant and a fluorine atom-containing surfactant are preferably used. The silicon atom-containing surfactant is especially preferred in that it minimizes printing contamination. The content of the surfactant is preferably from 0.01 to 3% by weight, and more preferably from 0.03 to 1% by weight based on the total weight of the hydrophilic layer (or the solid content of the coating liquid).

As for the present invention, an organic matting agent is contained in any layer on a backing layer side. It is especially preferable that an organic matting agent is contained in an outermost layer on a backing layer side. The organic polymer matting agent used in the invention is preferably an organic matting agent consisting of an organic polymer. Examples of the organic polymer include acryl resin, vinyl chloride resin, vinyl acetate resin, styrene resin, vinylidene chloride resin, acetal resin, and cellulose resin. These resins are preferably used in the form dispersed as particles with an average particle size of 0.5 to 20 μm, and preferably 1 to 10 μm in water or in a water-soluble polymer such as gelatin or polyacrylamide.

Examples of polymer used for the organic matting agent will be listed below, but the invention is not limited thereto.

(1) Acryl resin: polymethyl methacrylate, polyethyl methacrylate, polypropyl methacrylate, polydimethylaminoethyl methacrylate, polymethyl acrylate, polyethyl acrylate, polymethoxyethyl acrylate, etc.
(2) Acryl copolymer resin: copolymers of the monomers described in item (1) above with vinyl chloride, vinylidene chloride, vinylpyridine, styrene, acrylonitrile, acrylic acid, or methacrylic acid, etc.
(3) Vinyl chloride resin: polyvinyl chloride, copolymer of vinyl chloride with vinyl acetate, vinylidene chloride, acrylic acid, methacrylic acid, maleic acid, maleic ester, or acrylonitrile, etc.
(4) Polyvinyl acetate or its partially saponified resin
(5) Styrene resin: Polystyrene, copolymer of styrene with acrylonitrile, etc.
(6) Vinylidene chloride resin: polyvinylidene chloride, copolymer of vinylidene chloride with acrylonitrile, etc.
(7) Acetal resin: polyvinyl formal, polyvinyl butyral, etc.
(8) Cellulose: cellulose acetate, cellulose propionate, cellulose butyrate, cellulose nitrate, etc.
(9) Melamine resin: melamine-formaldehyde resin, benzoguanamie-melamine-formaldehyde resin, etc.

A dispersion of these organic matting agents can be obtained according to a method in which the polymers are dissolved in an organic solvent and mixed in water or an aqueous gelatin solution with vigorous stirring, a method in which the polymer is precipitated in form of particles during emulsion polymerization, precipitation polymerization, or pearl polymerization of monomers, or a method in which the matting agent particles are dispersed in water or an aqueous gelatin solution employing a stirrer, a homogenizer, a colloid mill, a flow jet mixer or an ultrasonic dispersion device.

The organic matting agent has an average particle size of preferably from 0.5 to 10 μm, more preferably from 0.7 to 35 μm, and still more preferably from 1 to 5 μm. In the invention, the average particle size of the organic matting agent can be obtained by calculating the diameter of a circle corresponding to the projected area in the electron microscope photograph of the organic matting agent. The content of the organic matting agent in the organic matting agent-containing layer is preferably from 0.01 to 1 g/$m^2$, and more preferably from 0.05 to 0.5 g/$m^2$.

In the invention, the surface roughness Ra of the backing layer side surface should be 0.1 to 6 μm in order to prevent the elongation of a printing plate during printing.

In the present invention, the surface roughness Ra means the center line average surface roughness (arithmetic average roughness). When a roughness curve is represented by formula Y = f(X) in a roughness curve with a length L in the center line direction which is extracted from a roughness curve obtained by being measured according to a needle contact meter, the direction of the center line of the curve being set as the X-axis and the direction perpendicular to the X-axis as the Y-axis, the surface roughness Ra (μm) is represented by the following equation. (Determination of the length L and measurement of the average roughness are carried out according to JIS-B-0601.)

$$Ra = \frac{1}{L}\int_0^L |f(x)|dx$$

After samples were stored at 25 °C and 65% RH for 24 hours so that the samples do not overlap with each other, the center line average surface roughness Ra was measured at 25 °C and 65% RH. Herein, as a method in which the films are not overlapped with each other, there is one in which the film at the edge portion is wound around a roll, one in which an inter leaf is inserted leaf by leaf between films, or one in which the sample sheet is put sheet by sheet on frames composed of a carton board. Examples of the surface roughness meter used in the invention include a non-contact type three dimension microscopic surface configuration measuring system RSTPLUS produced by WYKO Co., Ltd.

The following methods can be combined in order to obtain Ra falling within the range between o.1 and 6 μm.

(a) Binder for at least one layer on the backing layer side contains gelatin in an amount of from 0.5 to 5 g/$m^2$, the gelatin being hardened with a hardener.

(b) Any arbitrary layer on the backing layer side contains an organic matting agent with an average particle size of from 0.5 to 10 μm.

(C) A coating solution for a component layer on the backing layer side is coated on a substrate, constant rate-dried, and then dried at not more than 40 °C for 20 seconds or more. The resulting material is wound around a take-up spool to be in roll form.

As for item (a), binder for at least one layer on the backing layer side contains gelatin in an amount of from 0.5 to 5 g/$m^2$ being hardened with a hardener. Note that gelatin and hardener have been described before.

As for item (b), the organic matting agent contained in any arbitrary layer on the backing layer side has an average particle size of preferably from 0.5 to 10 μm. It is especially preferred that the organic matting agent is contained in an outermost layer on the backing layer side. Note that the organic matting agent has been described before.

As for item (C), it is preferred that a coating solution for a component layer on the backing layer side is coated on a substrate, constant rate-dried, and then dried at not more than 40 °C for 20 seconds or more, and the resulting material is wound around a take-up spool to be in roll form.

A planographic printing plate material comprising a silver halide emulsion layer is generally prepared according to a process in which a component element layer solution is coated employing a dip coating method, a air-knife coating method, a curtain coating method, or an extrusion coating method (these coating methods are detailed in Hara Yuji, Coating Technology, page 253 to 277, Showa 46, published by Asakura Shoten), cooling-set employing cold air, transported in constant rate drying, decreasing rate drying, and conditioning, employing a hanging type transporting method, an arch type transporting method, a meander type transporting method, or an air-supported transporting method.

The constant rate drying in the present invention is a drying process in which an evaporation amount of solvents per unit time, i.e., the evaporation rate of the solvents, is constant. The decreasing rate drying in the present invention is a drying process after constant rate drying in which the evaporation rate of solvent is gradually reduced, no evaporation is almost identified, and the coated layer has an equilibrium moisture content under ambient temperature and humidity. The cooling set is carried out employing cold air of from 5 to 15 °C. The constant rate drying is carried out supplying air with a dry-bulb temperature of 20 to 50 °C and a relative humidity of 10 to 35% according to the drying state of the coated layer. In the present invention, it is preferred that the coated layer is constant rate-dried, decreasing rate-dried, and dried at not more than 40 °C for 20 seconds or more, and the resulting material is wound around a take-up spool to be in roll form.

The planographic printing plate material in roll form is cut into an intended size, and packed in a packaging material described later.

In the planographic printing plate material of the present invention, the surface on the backing layer side has preferably a specific resistance of 1 x $10^9$ Ω or more and of not more than 2 x $10^{13}$ Ω. The planographic printing plate material has been stored at 23 °C and 20% RH for 24 hours and immediately after this, the specific resistance as defined in the present invention was determined in the same room, employing a specific resistance meter (for example, Teraohm Meter Model VE-30 produced by Kawaguchi Denki Co., Ltd.).

The methods for preparing a specific resistance falling within the range as defined in the present invention include the following methods 1 through 3, and a combination thereof.

(1) An electrically conductive layer is provided between the support and the silver halide emulsion layer, or on the backing layer side.
(2) The total dry thickness of layers provided on the backing layer side is from 1 to 8 µm.
(3) At least one of layers provided on the backing layer side contains polymer latex with -30 to 40 °C in glass transition temperature Tg.

The methods 1 through 3 above will be explained below.

(1) An electrically conductive layer is provided between the support and the silver halide emulsion layer, or on the backing layer side.

Examples of the electrically conductive layer in the present invention include a layer containing a water-soluble salt (such as a chloride or nitrate), a vapor-deposited metal layer, water-insoluble inorganic salts described in the specification of U.S. Patent No. 3,428,451, electrically conductive metal oxides described later, or electrically conductive compounds such as electrically conductive polymers including ionic polymers described in the specifications of U.S. Patent Nos. 2,861,056 and 3,206,312. Of these, a layer containing the electrically conductive metal oxides or the electrically conductive polymers is preferred.

Preferred electrically conductive compounds are electrically conductive metal oxides as shown below.

The electrically conductive compounds include electrically conductive polymers, metal oxides, and electrically conductive carbon black.

The electrically conductive polymer is preferably a water-soluble electrically conductive polymer, and it has an antistatic function in combination with hydrophobic polymer particles and a hardening agent.

As the water-soluble electrically conductive polymer, there is a polymer having at least one electrically conductive group selected from a sulfonic acid group, a sulfuric acid ester group, a quaternary ammonium group, and a carboxyl group, wherein the polymer has not more than 5% by weight per one polymer molecule. The water-soluble electrically conductive polymer may have a hydroxyl group, an amino group, an aziridine group, an active methylene group, a sulfinic acid group, an aldehyde group, or a vinyl sulfone group. The water-soluble electrically conductive polymer has a molecular weight of preferably from 3,000 to 100,000, and more preferably from 3,500 to 70,000. Examples of the water-soluble electrically conductive polymer include a polymer as disclosed in for example, items [0033] to [0046] of Japanese Patent O.P.I. Publication No. 7-20596.

The electrically conductive polymer can be synthesized by polymerizing a monomer prepared according to a conventional method or a monomer available on the market. The content of the electrically conductive polymer is preferably from 0.01 to 10 g/$m^2$, and more preferably from 0.1 to 5.0 g/$m^2$. The electrically conductive polymer can form the electrically conductive layer in the invention singly or in combination with other hydrophilic binders or hydrophobic binders. As the hydrophilic binders, gelatin, polyacrylamide, colloidal albumin, cellulose acetate, cellulose nitrate, polyvinyl alcohol, hydrolyzed polyvinyl acetate, or phthalated gelatin is advantageously used. As hydrophilic binders, there are a polymer having a molecular weight of 20,000 to 1,000,000 or more, styrene-butyl acrylate-acrylic acid copolymer, butyl acrylate-acrylonitrile-acrylic acid copolymer, and methyl methacrylate-ethyl acrylate-acrylic acid copolymer.

The hydrophobic polymer particles used in the electrically conductive layer are latex particles which are insoluble in water. The hydrophobic polymers are not specifically limited, but include polymers obtained by polymerizing a monomer selected from styrene, styrene derivative, alkyl acrylate, alkyl methacrylate, olefin derivative, halogenated ethylene, vinyl ester, and acrylonitrile. The hydrophilic polymer is preferably a polymer having styrene, alkyl acrylate, alkyl methacrylate in an amount of preferably at least 30 mol%, and more preferably 50 mol% or more.

In order to obtain latex of the hydrophobic polymer, an emulsion polymerization method or a dispersion method, in which the polymer is dissolved in a low boiling point solvent, followed by evaporation of the solvent, can be used, but the emulsion polymerization method is preferred in obtaining fine particles with a uniform particle size. The molecular weight of the hydrophobic polymer is preferably 3,000 or more. Examples of the hydrophobic polymer include a polymer as disclosed in for example, items [0052] to [0057] of Japanese Patent O.P.I. Publication No. 7-20596. The content of the hydrophobic polymer is preferably from 0.01 to 10 g/$m^2$, and more preferably from 0.1 to 5.0 g/$m^2$.

In the above emulsion polymerization, a surfactant can be used. As the dispersant used with the dispersion method, a non-ionic surfactant is used, and typically, a polyalkylene oxide is preferably used. The polyalkylene oxide is a compound having a polyalkylene oxide-chain segment of 3 or more to not more than 500. The polyalkylene oxide can be synthesized by condensation of polyalkylene oxide with a compound having active hydrogen such as aliphatic alcohol, phenols, fatty acid, aliphatic mercaptan, or organic amines, or by condensation of polyols

such as polypropylene glycol or polyoxytetramethylene with aliphatic mercaptan, organic amines, ethylene oxide or propylene oxide.

The polyalkylene oxide may be a polymer consisting of one kind of polyalkylene oxide-chain segments, or a block copolymer in which two or more kinds of polyalkylene-chain segments are combined through another chain segment in the copolymer molecule. A degree of polymerization of the polyalkylene oxide in the block copolymer is preferably from 3 or more to not more than 100 in total. Examples of the polyalkylene oxide used in the present invention include those disclosed in Japanese Patent Publication No. 2805012.

The hardener used in the electrically conductive layer is preferably a hydroxyl-containing epoxy hardener, and is more preferably a reaction product [CA] of polyglycidol with epihalohydrin. This product is considered to be a mixture in view of its synthetic method, however, it is not important whether or not it is a mixture, since the effect of the present invention can be obtained by controlling the number of a hydroxyl group or an epoxy group in the product. The product may be a mixture or a compound. Examples of the product include those disclosed in paragraphs [0062] to [0073] of Japanese Patent O.P.I. Publication No. 7-20596.

Next, a metal oxide as the electrically conductive compound will be explained.

Crystalline metal oxide particles are preferred as metal oxide. Metal oxides containing oxygen defects or a small amount of a hetero atom as a donor are preferred, since they generally have high electroconductivity. The latter metal oxides, containing a small amount of a hetero atom as a donor, are especially preferred, since it does not have adverse effects such as fog on the silver halide emulsion layer.

The metal oxides are preferably $ZnO_2$, $TiO_2$, $SnO_2$, $Al_2O_3$, $In_2O_3$, $SiO_2$, MgO, BaO, $MoO_3$, $V_2O_5$, and composite metal oxides thereof, and more preferably $ZnO_2$, $TiO_2$, and $SnO_2$. As the metal oxides containing a hetero atom, $SnO_2$ doped with Sb or $TiO_2$ doped with Nb or Ta is effective. The doping amount of the hetero atom is preferably from 0.01 to 30 mol%, and more preferably from 0.1 to 10 mol%. Additionally, shapes of those metal oxides may include any of those forms such as a spherical shape, a plate shape, a needle shape, a fiber shape and an indeterminate shape. The foregoing metal oxides having 0.001 to 1.0 μm in size are preferable and having 0.001 to 0.3 μm in size are further preferable.

The metal oxide particles used in the present invention are electrically conductive, and have a volume resistivity of preferably not more than $1 \times 10^7$ Ωcm, and more preferably not more than $1 \times 10^5$ Ωcm. Examples of the metal oxide include those disclosed in Japanese Patent O.P.I. Publication Nos. 56-143431, 56-120519, and 58-62647. The metal oxide particles are used in the form dispersed or dissolved in a binder. The binder used is not specifically limited, as long as it can form a film.

The content by volume of the metal oxide in the electrically conductive layer is preferably higher in order to reduce a specific resistance of the electrically conductive layer employing the metal oxides, and the content of the metal oxide in the electrically conductive layer is 5% or more by weight in obtaining an electrically conductive layer with sufficient strength. Therefore, the content by volume of the metal oxide in the electrically conductive layer is preferably from 5 to 95%. The added amount of the metal oxide in the electrically conductive layer is preferably from 0.05 to 10 g/$m^2$, and more preferably from 0.01 to 5.0 g/$m^2$. The added amount above provides an intended anti-static property.

As the electrically conductive carbon black used in the present invention, there are acetylene black, which is obtained according to a continuous cracking method which introduces an acetylene gas into a heated reaction furnace to cause cracking and elevate the furnace temperature, whereby cracking automatically proceeds; soot obtained due to incomplete combustion of oil, tar or resins by indirect flame; another electrically conductive carbon black such as high structure furnace black; and a mixture thereof. The particle size of the carbon black is preferably not more than 100 μm, and more preferably from 0.01 to 2 μm. The carbon black of 100 μm or more contaminates the coated layer, and cannot be sufficiently dispersed, so that a layer, in which the carbon black is uniformly dispersed, is not obtained. This loses commercial value. The electrically conductive carbon black in the present invention is black, and also has an anti-halation property.

Of the electrically conductive compounds described above, the electrically conductive compound in the present invention is preferably an electrically conductive polymer or a metal oxide.

In the present invention, it is preferred that the electrically conductive layer containing the electrically conductive compound is provided between the support and the silver halide emulsion layer, or on the backing layer side. Provision of the electrically conductive layer improves an electrostatic property, and decreases dust deposition, greatly reducing white spot faults during printing.

(2) The total dry thickness of layers provided on the backing layer side being from 1 to 8 μm.

In the present invention, at least one subbing layer is provided on the surface of the plastic sheet support opposite the silver halide emulsion layer.

The subbing layer in the present invention may be a layer having an anti-reflection property, or an electrically conductive layer containing an electrically conductive compound. Further, one or more layers having another function may be provided on the electrically conductive layer. It is preferred in the present invention that the electrically

conductive layer or at least one protective layer is provided on the subbing layer side, and the total dry thickness of layers provided on the backing layer side is from 1 to 8 μm.

(3) Binder for at least one of layers provided on the backing layer side contains polymer latex with -30 to 40 °C in glass transition temperature Tg. Polymer latexes used are as described before.

In the present invention, the plastic support is preferably a plastic film sheet. Examples of the plastic include polyethylene terephthalate, polyethylene naphthalate, polyimide, polyamide, polycarbonate, polysulfone, polyphenylene oxide, and cellulose ester.

The support in the present invention has a coefficient of elasticity at 120 °C (E120) of preferably from 9.80 x $10^2$ to 5.88 x $10^3$ MPa, and more preferably from 1.18 x $10^3$ to 4.90 x $10^3$ MPa, in view of the above handling property. Examples of such a support include a sheet of polyethylene naphthalate (E120 = 4.02 x $10^3$ MPa), polyethylene terephthalate (E120 = 1.47 x $10^3$ MPa), polybutylene naphthalate (E120 = 1.57 x $10^3$ MPa), polycarbonate (E120 = 1.67 x $10^3$ MPa), syndiotactic polystyrene (E120 = 2.16 x $10^3$ MPa), polyetherimide (E120 = 1.86 x $10^3$ MPa), polyarylate (E120 = 1.67 x $10^3$ MPa), polysulfone (E120 = 1.76 x $10^3$ MPa), and polyethersulfone (E120 = 1.67 x $10^3$ MPa). These plastics may be used singly or as a mixture of two or more thereof. Two or more of these sheets may be laminated. Especially preferred support is a polyethylene naphthalate sheet or a polyethylene terephthalate sheet.

The coefficient of elasticity herein referred to is a slope of the straight line portion in the stress-strain diagram showing the relationship between strain and stress, which is obtained employing a tension test meter according to JIS C2318. This slope is called Young's modulus. In the present invention, it is defined that the foregoing Young's modulus is the coefficient of elasticity.

The plastic support in the present invention has an average thickness of preferably in the range between 110 and 300 μm, and a thickness dispersion of preferably not more than 10%, in that a handling property is improved when the foregoing planographic printing plate material is mounted on a press. The average thickness of the support as described above is preferably from 110 to 300 μm, more preferably from 120 to 280 μm, and still more preferably from 150 to 260 μm.

The thickness dispersion of the plastic support in the present invention is preferably not more than 10%, more preferably not more than 8%, and still more preferably not more than 6%. The thickness dispersion of the support is determined according to the following: lines are formed at an interval of 10 cm in both the transverse and longitudinal directions on a 60 cm square polyester film sheet to form 36 small squares. The thicknesses of the 36 small squares are measured, and the average thickness, maximum thickness and minimum thickness are obtained. In order to obtain an average thickness or thickness dispersion of the support falling within the range described above, there is a method in which support forming conditions are optimized or the support prepared is treated with a smoothing roller while post heating, however, it is preferred in the present invention that the support is prepared according to the following procedures.

The support in the present invention is prepared by a method comprising the steps of melting a thermoplastic resin at a temperature of from the melting point (Tm) to Tm + 50 °C, filtering the melted resin through a filter, extruding the filtrate from a T-die, and casting it on a casting drum at a glass transition point (Tg) - 50 °C to Tg to form an unstretched sheet. As a method to obtain the support with the thickness variation falling within the above-described range, a static electricity application method is preferably used.

The foregoing unstretched sheet is stretched at from Tg to Tg + 50 °C by a stretching magnification of from 2 to 4 times. As another method to obtain the support with the thickness variation falling within the above-described range, a multi-stretching method is preferably used, in which temperature at a later stretching step is higher than that at a preceding stretching step by preferably 1 to 30 °C, and more preferably 2 to 15 °C. The stretching magnification at the preceding stretching step is preferably 0.25 to 0.75 times, and more preferably 0.3 to 0.5 times the stretching magnification at the later stretching step. Thereafter, it is preferred that the stretched sheet is maintained at Tg - 30 °C to Tg for 5 to 60 seconds, preferably 10 to 40 seconds, and stretched in the lateral direction at Tg to Tg + 50 °C by a stretching magnification of 2.5 to 5 times.

The resulting sheet, while held through a chuck at (Tm - 50 °C) to (Tm - 5 °C), is heat fixed for 5 to 120 seconds, where the interval of the chucks in the lateral direction is preferably reduced by more than 0 to 10% (heat relaxation). The heat fixed sheet is cooled, subjected to knurling treatment to give a knurl of 10 to 100 μm at the sheet edge, and wound around a spool. Thus, a multi-axially stretched film sheet is preferably obtained.

In order to increase adhesion between the plastic support and a coating layer, it is preferred that the surface of the support is subjected to adhesion increasing treatment or is coated with a subbing layer. Examples of the adhesion increasing treatment include corona discharge treatment, flame treatment, plasma treatment and UV light irradiation treatment. It is preferred that a layer containing gelatin or latex as a subbing layer is prepared on a support. The electrically conductive layer is preferably provided as the subbing layer.

The plastic support in the present invention is preferably a plastic film sheet, but may be a composite support in which a plate of a metal (for example, iron, stainless steel or aluminum) or a polyethylene-laminated paper sheet is

laminated onto the plastic film sheet. The composite support may be one in which the lamination is carried out before any layer is coated on the support, one in which the lamination is carried out after any layer has been coated on the support, or one in which the lamination is carried out immediately before mounted on a printing press.

Particles having a size of from 0.01 to 10 μm are preferably incorporated in an amount of from 1 to 1000 ppm into the support, in improving handling property. Herein, the particles may be organic or inorganic material. Examples of the inorganic material include silica described in Swiss Patent 330158, glass powder described in French Patent 296995, and carbonate salts of alkaline earth metals, cadmium or zinc described in British Patent 1173181. Examples of the organic material include starch described in U.S. Patent 2322037, starch derivatives described such as in Belgian Patent 625451 and British Patent 981198, polyvinyl alcohol described in JP-B 44-3643, polystyrene or polymethacrylate described in Swiss Patent 330158, polyacrylonitrile described in U.S. Patent 3079257 and polycarbonate described in U.S. Patent 3022169. The shape of the particles may be in a regular form or irregular form.

In the present invention, the plastic film sheet after stretched and heat-fixed is preferably subjected to heat treatment in order to obtain good transportability in a device such as an exposure device. After the sheet has been stretched, heat fixed, cooled, wound around a spool once, and unwound, the sheet is properly heat treated at a separate process as follows. As the heat treatment methods in the present invention, there are a transporting method in which the film sheet is transported while holding the both ends of the sheet with a pin or a clip, a transporting method in which the film sheet is roller transported employing plural transporting rollers, an air transporting method in which the sheet is transported while lifting the sheet by blowing air to the sheet (heated air is blown to one or both sides of the sheet from plural nozzles), a heating method which the sheet is heated by radiation heat from for example, an infrared heater, a heating method in which the sheet is brought into contact with plural heated rollers to heat the sheet, a transporting method in which the sheet hanging down by its own weight is wound around an up-take roller, and a combination thereof. Tension at heat treatment can be adjusted by controlling torque of an up-take roll and/or a feed-out roll and/or by controlling load applied to the dancer roller provided in the process. When the tension is changed during and/or after the heat treatment, an intended tension can be obtained by controlling load applied to the dancer roller provided in the step before, during and/or after the heat treatment. When the transporting tension is changed while vibrating the sheet, it is useful to reduce the distance the heated rollers.

In order to reduce dimensional change on heat treatment (heat processing), which is carried out later, without inhibiting thermal contraction, it is desirable to lower the transporting tension as much as possible, and lengthen the heat treatment time. The heat treatment temperature is preferably in the range of from Tg + 50 °C to Tg + 150 °C. In this temperature range, the transporting tension is preferably from 5 Pa to 1 MPa, more preferably from 5 Pa to 500 kPa, and most preferably from 5 Pa to 200 kPa, and the heat treatment time is preferably from 30 seconds to 30 minutes, and more preferably from 30 seconds to 15 minutes. The above described temperature range, transporting tension range and heat treatment time range can prevent the support planarity from lowering due to partial thermal contraction difference of the support occurring during heat treatment and prevent scrapes from occurring on the support due to friction between the support and transporting rollers.

In the present invention, it is preferred that the heat treatment is carried out at least once, in order to obtain an intended dimensional variation rate. The heat treatment can be optionally carried out two or more times.

In the present invention, the heat-treated plastic film sheet is cooled from a temperature of around Tg to room temperature and wound around a spool. During cooling to room temperature from a temperature exceeding Tg, the heat-treated polyester film sheet is preferably cooled at a rate of -5 °C/second or more in order to prevent lowering of flatness of the sheet due to cooling.

In the present invention, the heat treatment is preferably carried out after the subbing layer described later has been coated. There is, for example, a method in which the polyester film sheet is inline coated with the subbing layer between the heat fixing step and the cooling step, wound around a spool, and thereafter, the wound sheet is heat fixed or a method in which the heat fixed polyester film sheet, being wound around a spool, is coated with a subbing layer in a separate line to obtain a subbed polyester film sheet, and successively, the subbed film maintained horizontally is heat treated. Further, the same heat treatment as above may be carried out after various functional layers such as a backing layer, a conductive layer, a lubricant layer and a subbing layer have been coated.

It is preferred in the present invention that the planographic printing plate material has at least one hydrophilic layer and still more possesses a silver halide emulsion layer on the hydrophilic layer. The hydrophilic layer will be explained below. The hydrophilic layer is defined as a layer, which has low affinity to printing ink and high affinity to water, when the planographic printing plate material of the present invention is used for printing.

The hydrophilic layer in the present invention preferably contains gelatin as a binder. The gelatin content of the hydrophilic layer is ordinarily from 0.5 to 5 g/$m^2$, and preferably from 1 to 4 g/$m^2$. The gelatin is preferably inactive deionized gelatin. A part of the gelatin in the hydrophilic layer can be replaced with one or more kinds of a hydrophilic polymer such as water-soluble gelatin, starch, dextrin, albumin, sodium alginate, hydroxyethylcellulose, gum arabic, polyvinyl alcohol, polyvinyl pyrrolidone, carboxymethylcellulose, polyacrylamide, styrene-maleic anhydride copolymer, or vinyl methyl ether-maleic anhydride copolymer. A vinyl polymer aqueous dispersion (latex) can be added to the

gelatin layer. These binders described above are preferably hardened with a hardener.

The hardener is preferably the vinylsulfone compound described above. As the hardener, those ordinarily used as hardeners of a conventional photographic emulsion layer can be used. The hardener is preferably a vinylsulfone compound. The vinylsulfone compound can be used in combination with other hardeners such as organic hardeners, for example, urea-formalin resin, melamine-formalin resin, epoxy compounds, aziridine compounds, active olefins, and isocyanate compounds, and inorganic salts of polyvalent metals, chromium, aluminum and zirconium, which are well-known as hardeners for the photographic emulsion.

The vinyl sulfone compound used in the present invention is a compound having a vinyl group bonding to a sulfonyl group or a group capable of forming a vinyl group bonding to a sulfonyl group, and preferably a compound having two or more of a vinyl group bonding to a sulfonyl group or a group capable of forming a vinyl group bonding to a sulfonyl group.

Compounds represented by the following formula [VS-I], for example, are preferably used in the present invention.

Formula [VS-I]

$$L\text{-}(SO_2\text{-}X)_m$$

In formula [VS-I] above, L represents an m-valent linkage group, X represents $-CH=CH_2$ or $-CH_2CH_2Y$ in which Y represents a group capable of being released as HY by action of a base, for example, a halogen atom, a sulfonyloxy group, or a sulfoxy group (including its salt form, and m represents an integer of from 2 to 10, provided that when m is 2 or more, plural $(SO_2\text{-}X)$s may be the same or different. Examples of the m-valent linkage group L include an aliphatic hydrocarbon group (such as alkylene, alkylidene, alkylidine or their combination group), an aromatic hydrocarbon group (such as arylene or its combination group), -O-, -N(R')- (R' represents a hydrogen atom or an alkyl group having a carbon atom number of preferably from 1 to 15), -S-, -N<, -CO-, -SO-, $-SO_2-$, $-SO_3-$, and a group including one or more thereof, provided that when the linkage group has two or more of - N(R')-, two of (R')s may combine with each other to form a ring. The m-valent linkage groups L further include those having as a substituent a hydroxyl group, an alkoxy group, a carbamoyl group, a sulfamoyl group, an alkyl group or an aryl group. X is preferably $-CH=CH_2$ or $-CH_2CH_2Cl$.

Examples of the vinyl sulfone compound represented by formula [VS-I] above include compounds VS-1 through VS-64 disclosed in paragraphs [0041] through [0047] of Japanese Patent O.P.I. Publication No. 2000-258866.

Of the vinyl sulfone compounds represented by formula [VS-I] above, the most preferred compounds include the vinyl sulfone compound represented by formula [V] below:

Formula [V]

$$CH_2=CHSO_2\text{-}R^0\text{-}SO_2CH=CH_2$$

In formula [V], $R^0$ represents a divalent linkage group such as a substituted or unsubstituted alkylene group, provided that the divalent linkage group may be intervened with an amido linkage, an ether linkage or a thioether linkage. The vinyl sulfone compound represented by formula [V] has a molecular weight of preferably not more than 230.

Examples of the vinyl sulfone compound represented by formula [V] will be listed below.

| | | Mw |
|---|---|---|
| HD-1 | $CH_2CHSO_2CH_2SO_2CHCH_2$ | 196 |
| HD-2 | $CH_2CHSO_2CH_2CH_2SO_2CHCH_2$ | 210 |
| HD-3 | $CH_2CHSO_2CH_2CH_2CH_2SO_2CHCH_2$ | 224 |
| HD-4 | $CH_2CHSO_2CH_2OCH_2SO_2CHCH_2$ | 226 |

Examples of the vinyl sulfone compound used in the present invention include the aromatic compounds disclosed in the specification of German Patent No. 1,100,942 or the specification of US Patent No. 3,490,911, the alkyl compounds containing hetero atoms disclosed in Japanese Patent Nos. 44-29622, 47-25373, and 47-24259, sulfonamides or esters disclosed in Japanese Patent No. 47-8736, 1,3,5-tris[β-(vinylsulfonyl)-propyl]-hexahydro-s-triazine disclosed in Japanese Patent No. 49-24435, alkyl compounds disclosed in Japanese Patent No. 50-35807 and Japanese Patent O.P.I. Publication No. 51-44164, and compounds disclosed in Japanese Patent O.P.I. Publication No.

59-18944.

These vinyl sulfone compounds are dissolved in water or an organic solvent, and used in an amount of from 0.005 to 20% by weight, and preferably from 0.02 to 10% by weight based on the weight of binder.

Hardeners can be contained in all layers or in a specific layer constituting the planographic printing plate material. The addition method of the hardener to a coating solution may be carried out during preparation of the coating solution, during in-line coating, or immediately before coating.

In order to prevent halation, the hydrophilic layer preferably contains pigment such as carbon black or a dye.

In order to improve printability, the hydrophilic layer in the present invention can contain solid particles (for example, silica particles) with an average size of 1 to 10 μm. The hydrophilic layer can further contain a photographic agent such as a developing agent. A subbing layer may be provided which is disclosed in Japanese Patent O.P.I. Publication Nos. 48-5503, 48-100203, and 49-16507.

The halide composition of the silver halide used for planographic printing plate material can be any one of silver chloride, silver chlorobromide, silver iodochlorobromide, silver bromide, silver iodobromide and silver iodide. The silver halide in the present invention is preferably silver chloride, silver chlorobromide, or silver iodochlorobromide each containing silver chloride in an amount of 50 mol% or more. The photographic emulsion used in the present invention can be prepared according to the methods described in P. Glafkides, Chimie Physique Photographique (published by Paul Montel Corp., 19679; G.F. Duffin, Photographic Emulsion Chemistry (published by Focal Press, 1966); V.L. Zelikman et al., Making and Coating of Photographic Emulsion (published by Focal Press, 1964). Any one of acidic precipitation, neutral precipitation and ammoniacal precipitation is applicable and the reaction mode of a water-soluble silver salt and a water-soluble halide can be carried out by single jet addition, double jet addition or a combination thereof.

In order to improve intensity reciprocal law failure or to adjust contrast, the silver halide grains used in the present invention preferably contains complex ions or ions of metals belonging to from the 6th group to 10th group in the Periodical Table, and such metals are preferably W, Fe, Co, Ni, Cu, Ru, Rh, Pd, Re, Os, Ir, Pt, and Au. These metals may be incorporated into silver halide grains in the form of metal complex ions. In the present invention, transition metal complexes are preferably six-coordinate metal complexes or complex ions represented by the formula described below are preferred.

$$\text{formula } (ML_6)^m$$

wherein M represents a transition metal selected from elements belonging to from the 6th group to 10th group in the Periodical Table; L represents a ligand; and m represents 0, -1, -2, -3, or -4. Specific examples represented by L include halogens (fluorine, chlorine, bromine, and iodine), cyan, cyanato, thiocyanato, selenocyanato, tellurocyanato, a ligand such as azido or aquo, nitrosyl, thionitrosyl, etc., of which aquo, nitrosyl and thionitrosyl are preferred. When the aquo ligand is present, one or two ligands are preferably coordinated. L may be the same or different. The particularly preferred specific example of M is rhodium (Rh), ruthenium (Ru), rhenium (Re), iridium (Ir) or osmium (Os). Specific examples of transition metal ligand complexes are described below.

1: $[RhCl_6]^{3-}$
2: $[RuCl_6]^{3-}$
3: $[ReCl_6]^{3-}$
4: $[RuBr_6]^{3-}$
5: $[OsCl_6]^{3-}$
6: $[IrCl_6]^{4-}$
7: $[Ru(NO)Cl_5]^{2-}$
8: $[RuBr_9(H_2O)]^{2-}$
9: $[Ru (NO) (H_2O)Cl_4]^{-}$
10: $[RhCl_5(H_2O)]^{2-}$
11: $[Re(NO)Cl_5]^{2-}$
12: $[Re(NO)CN_5]^{2-}$
13: $[Re(NO)Cl(CN)_4]^{2-}$
14: $[Rh(NO)_2Cl_4]^{-}$
15: $[Rh (NO) (H_2O)Cl_4]^{-}$
16: $[Ru(NO)(CN)_5]^{2-}$
17: $[Fe(CN)_6]^{3-}$
18: $[Rh(NS)Cl_5]^{2-}$
19: $[Os(NO)Cl_5]^{2-}$

20: $[Cr(NO)Cl_5]^{2-}$
21: $[Re(NO)Cl_5]^{-}$
22: $[O_5(NS)Cl_4(TeCN)]^{2-}$
23: $[Ru(NS)Cl_5]^{2-}$
24: $[Re(NS)Cl_4(SeCN)]^{2-}$
25: $[Os(NS)Cl(SCN)_4]^{2-}$
26: $[Ir(NO)Cl_5]^{2-}$
27: $[Ir(NS)Cl_5]^{2-}$

The metals in these metal ions or metal complex ions may be used singly or as a mixture of two or more kinds thereof. The content of these metal ions or metal complex ions is suitably between $1 \times 10^{-9}$ and $1 \times 10^{-2}$ mole per mole of silver halide, and is preferably between $1 \times 10^{-8}$ and $1 \times 10^{-4}$ mole per mole of silver halide. Compounds, which provide these metal ions or complex ions, are preferably incorporated into silver halide grains through addition during the silver halide grain formation. These may be added during any preparation stage of the silver halide grains, that is, before or after nuclei formation, growth, physical ripening, and chemical ripening. However, these are preferably added at the stage of nuclei formation, growth, and physical ripening; furthermore, are preferably added at the stage of nuclei formation and growth; and are most preferably added at the stage of nuclei formation. These compounds may be added several times by dividing the added amount. Uniform content in the interior of a silver halide grain can be carried out. As described in each of Japanese Patent O.P.I. Publication Nos. 63-29603, 2-306236, 3-167545, 4-76534, 6-110146, 5-273683 and so forth, incorporation can be carried out so as to result preferably in distribution formation in the interior of a grain. These metal compounds can be dissolved in water or a suitable organic solvent (for example, alcohols, ethers, glycols, ketones, esters, amides, etc.) and then added. Furthermore, there are methods in which, for example, an aqueous metal compound powder solution or an aqueous solution in which a metal compound is dissolved along with NaCl and KCl is added to a water-soluble silver salt solution during grain formation or to a water-soluble halide solution; when a silver salt solution and a halide solution are simultaneously added, a metal compound is added as a third solution to form silver halide grains, while simultaneously mixing three solutions; during grain formation, an aqueous solution comprising the necessary amount of a metal compound is placed in a reaction vessel; or during silver halide preparation, dissolution is carried out by the addition of other silver halide grains previously doped with metal ions or complex ions. Specifically, the preferred method is one in which an aqueous metal compound powder solution or an aqueous solution in which a metal compound is dissolved along with NaCl and KCl is added to a water-soluble halide solution. When the addition is carried out onto grain surfaces, an aqueous solution comprising the necessary amount of a metal compound can be placed in a reaction vessel immediately after grain formation, or during physical ripening or at the completion thereof or during chemical ripening. When the addition is carried out onto grain surfaces, an aqueous solution comprising the necessary amount of a metal compound can be placed in a reaction vessel immediately after grain formation, or during physical ripening or at the completion thereof or during chemical ripening.

The light sensitive silver halide grains can be desalted using the methods known in the art, such as the noodle washing method and flocculation process.

The light sensitive silver halide grains in this invention may be subjected to chemical sensitization. Preferred chemical sensitizations include chemical sensitizations commonly known in the art, such as sulfur sensitization, selenium sensitization, tellurium sensitization, noble metal sensitization using gold compounds or platinum, palladium and iridium compounds, and reduction sensitization. As compounds used for sulfur sensitization, selenium sensitization, or tellurium sensitization, commonly known compounds can be used, for example, as described in JP-A No. 7-128768. Examples of preferred compounds used for noble metal sensitization include chloroauric acid, potassium chloroaurate, potassium auriothiocyanate, gold selenide, gold selenide and compounds described in the specification of U.S. Patent No. 2,448,060 and the specification of British Patent No. 618,061. Examples of compounds used for reduction sensitization include stannous chloride, aminoiminomethanesulfinic acid, hydrazine derivatives, borane compounds, silane compounds and polyamini compounds as well as ascorbic acid and thiourea dioxide. The reduction sensitization can be conducted ripening the emulsion at a pH of not less than 7 or at a pAg of not more than 8.3. Further, reduction sensitization can be achieved by single introduction of silver ions during the grain formation.

The silver halide emulsion is preferably subjected to spectral sensitization by a spectral sensitizing dye to have sensitivity in intended wavelength regions. Particularly when the planographic printing plate material of the present invention is applied to CTP, it is exposed to laser which is installed in an exposure device, and therefore, the silver halide grains are preferably subjected to spectral sensitization to be applied to helium-neon laser, argon laser, LED, and semiconductor laser. In the present invention, preferred spectral sensitizing dyes for a helium-neon laser, a red LED or a red semiconductor laser include those disclosed in paragraphs [0011] through [0204] of Japanese Patent O.P.I. Publication No. 2000-122297, preferred spectral sensitizing dyes for an infrared semiconductor laser include those disclosed in paragraphs [0014] through [0059] of Japanese Patent O.P.I. Publication No. 6-230577, and preferred spectral sensitizing dyes for a blue semiconductor laser include those disclosed in paragraphs [0012] through [0023]

of Japanese Patent O.P.I. Publication No. 2001-350267.

The binder used in the silver halide emulsion layer is mainly gelatin, but a part of the gelatin can be replaced with the hydrophilic colloid described in the hydrophilic layer above. The gelatin content of the silver halide emulsion is from 0.3 to 2 g/$m^2$, and preferably from 0.5 to 1.5 g/$m^2$. The silver halide emulsion is preferably hardened with a hardener. As the hardener, those ordinarily used for hardeners of a conventional photographic emulsion layer can be used. The hardener is preferably a vinylsulfone compound. The vinylsulfone compound can be used in combination with other hardeners such as organic hardeners, for example, urea-formalin resin, melamine-formalin resin, epoxy compounds, aziridine compounds, active olefins, and isocyanate compounds, and inorganic salts of polyvalent metals, chromium, aluminum and zirconium, which are well-known as hardeners for the photographic emulsion.

It is important in manufacturing the planographic printing plate material of the present invention that the light sensitive silver halide emulsion layer be hardened. It is necessary that the light sensitive silver halide emulsion layer be sufficiently hardened before printing. The hardener may be added to a photographic emulsion layer coating solution in a similar manner as a conventional photographic emulsion is hardened. The photographic emulsion layer may be hardened, for example by heating, before or after development or processing of the planographic printing plate material. In order to obtain stable hardening, it is preferred that a silver halide emulsion containing a hardener is coated on a substrate, dried, and then heat-treated at appropriate temperature. The heat-treatment is one for obtaining stable hardening, and may be carried out at 80 to 150 °C for several minutes to several tens minutes, or at 30 to 50 °C for several days (1 to 20 days).

Particles with a particle size of from 2 to 10 μm are preferably added to the silver halide emulsion layer in order to prevent its abrasion during printing. As the particles, particles of silica, talc, seeklite, or rice starch can be used, but silica particles are preferred. The silica particles are added in an amount of from 0.01 to 1 g/$m^2$ to the silver halide emulsion layer. Excessively high silica particle content results in scumming or in lowering of ink density during printing.

It is preferred that so-called antireflection dyes or pigment are applied in order to improve image sharpness, i.e., resolution or sharpness of final printing images. These dyes or pigment are added to the silver halide emulsion layer on a substrate, so-called an anti-reflection layer provided between the silver halide emulsion layer and the substrate, or a layer provided on the side of the substrate opposite the silver halide emulsion layer.

A physical developing nucleus layer, which is an image receiving layer in the silver salt diffusion transfer process, is provided on silver halide emulsion layer surface farther than the support. Examples of the physical developing nucleus include colloid particles of metals such as silver, antimony, bismuth, cadmium, cobalt, lead, nickel, palladium, rhodium, gold, or platinum, particles of sulfides, polysulfides or selenides of these metals, a mixture thereof and mixed crystals thereof. The physical developing nucleus layer preferably contains a hydrophilic binder in an amount of from 0.5 to 50 mg/$m^2$, Examples of the hydrophilic binder include gelatin, starch, dialdehyde starch, carboxymethyl cellulose, gum arabic, sodium alginate, hydroxyethyl cellulose, polystyrene sulfonic acid, a copolymer of vinyl imidazole and acrylamide disclosed in Japanese Patent O.P.I. Publication No. 53-21602, a copolymer of acrylamide and methyl sulfone having a guanylthiourea unit disclosed in Japanese Patent O.P.I. Publication No. 8-211614. The physical developing nucleus layer may contain a developing agent such as hydroquinone, methylhydroquinone or catechol, or the hardener described above. The pH of a coating solution for the physical developing nucleus layer is in the weak acidic or acidic regions, and typically the pH is ordinarily from 1.6 to 4.0, and preferably from 1.6 to 3.5.

In the present invention, as described above, the hydrophilic layer is preferably provided between the support and the silver halide emulsion layer. Each of the coating solutions for the hydrophilic layer, silver halide emulsion layer, and the physical developing nucleus layer may contain an anionic, cationic or non-ionic surfactant, an anti-foggant, a matting agent, a viscosity increasing agent, or an anti-static agent.

The planographic printing plate material manufactured above was cut into an intended size, wound around a spool to be in roll form, packed in a packaging material and stored till the material is subjected to exposure for image formation as described later. It is preferred that the planographic printing plate material is wound around a core with a diameter of from 4 to 10 μm to be in the form of roll. In order to endure a long term storage, the packaging material is preferably one having an oxygen permeability of not more than 50 ml/atm·$m^2$·30 °C·day as disclosed in Japanese Patent O.P.I. Publication No. 2000-206653. As another embodiment, the packaging material is also preferred which has a moisture permeability of not more than 10 g/atm·$m^2$·25 °C·day as disclosed in Japanese Patent O.P.I. Publication No. 2000-206653.

In the present invention, the laser used for exposure may be one which emits light having a visible to infrared wavelength regions. The laser may be a gas laser or a semiconductor laser. Scanning exposure is preferably carried out employing these lasers.

A device suitable for the scanning exposure may be any device capable of forming an image with the laser on the planographic printing plate material according to image signals from a computer. An external cylinder process in which the planographic printing plate material provided along the outer peripheral wall of an exposure cylinder having a diameter of 250 mm or more is subjected to scanning exposure in the rotational direction (in the main scanning

direction) of the cylinder, employing one or several lasers located outside the cylinder, moving the lasers in the normal direction (in the sub-scanning direction) to the rotational direction of the cylinder or an internal cylinder process in which the planographic printing plate material provided along the inner peripheral wall of a half cylinder for exposure is subjected to scanning exposure in the rotational direction (in the main scanning direction) of the cylinder, employing one or several lasers located inside the cylinder, moving the lasers in the normal direction (in the sub-scanning direction) to the rotational direction of the cylinder.

In the present invention, a preferred exposure device is an exposure device comprising a laser, an exposure cylinder, and a planographic printing plate material comprising a plastic film sheet wound around in roll form and provided thereon, a hydrophilic layer, a silver halide emulsion layer, a physical development nucleus layer and a backing layer, wherein the material is unwound, fed onto the exposure cylinder, fixed to the cylinder surface under reduced pressure, and then imagewise exposed to laser beams according to image data.

A developer in the present invention can contain an alkali such as sodium hydroxide, potassium hydroxide, lithium hydroxide or sodium phosphate; a preserver such as sulfite; a silver halide-solubilizing agent such as thiosulfate, thiocyanate, cyclic imide, 2-mercaptobenzoic acid or amines; a thickner such as hydroxyethylcellulose or carboxymethylcellulose; an Antifoggant such as potassium bromide or a compound disclosed in Japanese Patent O.P.I. Publication No. 47-26201; a developing agent such as hydroquinone, catechol, or 1-phenyl-3-pyrazolidone; or a development modifier such as polyoxyalkylene compounds or onium compounds. The developer can further contain a compound for improving ink receptivity of silver surface as disclosed in the specification of US Patent No. 3,776,728.

A silver surface at the time after developing the printing plate in the present invention is converted to ink receptivity by a given, known surface treatment agent and the receptivity can be intensified. Such a treatment agent, for example, is disclosed in Japanese Patent Examined Publication No. 48-29723 and in the specification of US Patent No. 3,776,728. The printing method, desensitization agent, absorbent, and so forth which are used can be those obtained by a well known method.

In the case of color printing in the present invention, it is preferred that after fine through-holes, so-called pinholes for positioning, are produced in advance in a printing plate, the printing plate is placed on a plate cylinder of a printing press with reference to positions of the pinholes. By doing so, in the case of color printing, for example, four color printing, a position of the printing plate becomes constant, so that "out of color registration" does not appear. There are two kinds of pinholes for printing such as horseshoe shaped and rectangular pinholes as typical examples of pinholes for positioning though shapes of pinholes depend on the kind of printing press.

## EXAMPLE

The present invention will be detailed employing the following examples, but the present invention is not limited thereto.

Example 1

<<Preparation of support>>

Employing terephthalic acid and ethylene glycol, polyethylene terephthalate having an intrinsic viscosity VI of 0.66 (at 25 °C in a phenol/tetrachloroethane (6/4 by weight) solvent) was prepared according to a conventional method. The resulting polyethylene terephthalate was formed into pellets, dried at 130 °C for 4 hours, and melted at 300 °C. The melted polyethylene terephthalate was extruded from a T-shaped die onto a 50 °C drum, and rapidly cooled. Thus, an unstretched sheet having an average thickness of 190 μm was obtained. The sheet was stretched in the mechanical direction at 102 °C by a stretching magnification of 1.3, and then at 110 °C by a stretching magnification of 2.6. Successively, the stretched sheet was further stretched at 100 °C by a stretching magnification of 4.5 in the transverse direction in a tenter. The resulting sheet was heat fixed at 240 °C for 20 seconds and relaxed at 240 °C in the transverse direction by 4%. Thereafter, the sheet at the chuck portions in the tenter was cut off, and the both edges in the transverse direction of the sheet were subjected to knurling treatment. The knurled sheet was cooled to 40 °C, and wound around an up-take spool at a tension of 4.8 kg/m. The width of the thus obtained polyethylene terephthalate sheet had a width of 2.5 m. The thickness dispersion of the sheet was 3%.

<<Preparation pf subbed support>>

The both surfaces of the support prepared above were subjected to corona discharge treatment at 8 W/ $m^2$·minute. Subsequently, the following subbing layer coating solution "a" was coated on one side of the support to give a first subbing layer with a dry thickness of 0.8 μm, and further, a subbing layer coating solution "b" was coated on the resulting layer to give a second subbing layer with a dry thickness of 0.1 μm, while carrying out corona discharge

treatment (at 8 W/m$^2$·minute), each layer being dried at 180 °C for 4 minutes (subbing layer surface A). The following subbing layer coating solution "c-1", "c-2", or "c-3" as shown in Table 1 described later was coated on the side of the support opposite the first subbing layer to give a third subbing layer with a dry thickness of 0.8 μm, and further, the following subbing layer coating solution "d-1", "d-2", or "d-3" as shown in Table 1 described later was coated on the resulting layer to give a fourth subbing layer with a dry thickness of 1.0 μm, while carrying out corona discharge treatment (at 8 W/m$^2$·minute), each layer being dried at 180 °C for 4 minutes (subbing layer surface B). Each of subbing layer surfaces was subjected to plasma treatment under conditions described later and the following heat treatment was further conducted.

<<Subbing layer coating solution “a”>>

| | |
|---|---|
| styrene/glycidyl methacrylate/butyl acrylate = 60/39/1 ternary system copolymer latex (Tg=75 °C) | 6.3% (in terms of solid content) |
| styrene/glycidyl methacrylate/butyl acrylate = 20/40/40 ternary system copolymer latex | 1.6% |
| Anionic surfactant S-1 | 0.1% |
| Water | 92.0% |

<<Subbing layer coating solution “b”>>

| | |
|---|---|
| Gelatin | 1% |
| Anionic surfactant S-1 | 0.05% |

| | |
|---|---|
| Hardener H-1 | 0.02% |
| Matting agent (Silica particles with an average particle size of 3.5 μm) | 0.02% |
| Antifungal agent F-1 | 0.01% |
| Water | 98.9% |

S-1

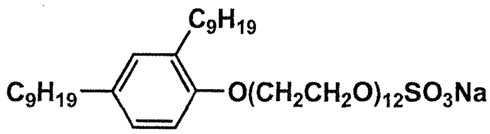

H-1

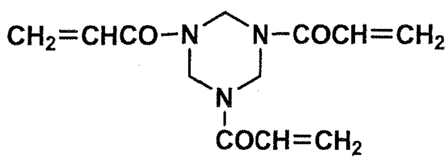

F-1

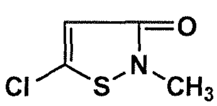

(Component A)

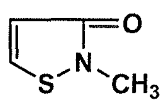

(Component B)

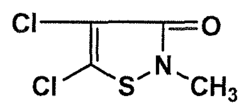

(Component C)

(Component A):(Component B):(Component C) =50:46:4 (by mole)

<<Subbing layer coating solution "c-1">>

| | |
|---|---|
| styrene/glycidyl methacrylate/butyl acrylate = 20/40/40 ternary system copolymer latex | 0.4% (in terms of solid content) |
| styrene/glycidyl methacrylate/butyl acrylate/ acetoacetoxyethyl methacrylate = 39/40/20/1 quaternary system copolymer latex | 7.6% |
| Anionic surfactant S-1 | 0.1% |

| | |
|---|---|
| Water | 91.9% |

<<Subbing layer coating solution "d-1">>

| | |
|---|---|
| Conductive composition of Component d-11 / Component d-12 /Component d-13 = 66/31/1 | 6.4% |
| Hardener H-2 | 0.7% |
| Anionic surfactant S-1 | 0.07% |
| Matting agent (Silica particles with an average particle size of 3.5 μm) | 0.03% |
| Water | 93.4% |

Component d-11: Copolymer (Anionic polymer) of styrene sulfonic acid/maleic acid = 50/50

Component d-12: styrene/glycidyl methacrylate/butyl acrylate = 20/40/40 ternary system copolymer latex

Component d-13: Copolymer (Polymer surfactant) of styrene/sodium isoprene sulfonate = 80/20

**H-2**

Mixture of three compounds below

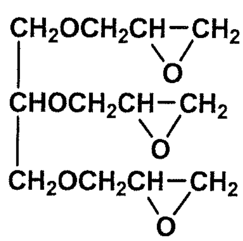

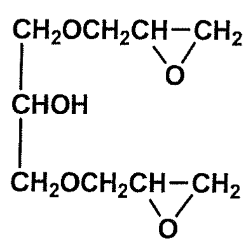

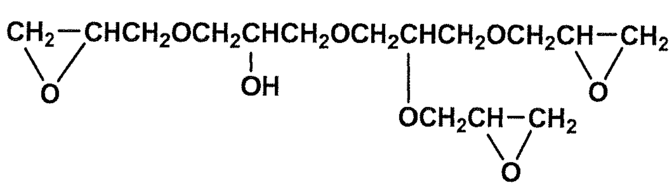

<<Subbing layer coating solution "c-2">>

Julimer ET-410 (Tg=52 °C) (produced by Nippon Junyaku Co., Ltd.) 21%

$SnO_2$/Sb (9/1 by weight) particles (average particle size: 0.25 μm) 67%

Matting agent polymethyl methacrylate (average particle size: 5 μm) 4%
Denacol EX-614B (produced by Nagase Kasei Kogyo Co., Ltd.) 7%

<<Subbing layer coating solution "d-2">>

PVdC polymer latex (Core-shell type latex containing particles comprised of 90% by weight of core and 10% by weight of shell, the core comprised of a copolymer of vinylidene chloride/methyl acrylate/methyl methacrylate/acrylonitrile/acrylic acid {93/3/3/0.9/0.1 (% by weight)}, and the shell comprised of a copolymer of vinylidene chloride/methyl acrylate/methyl methacrylate/acrylonitrile/acrylic acid {88/3/3/3/3 (% by weight)}, the weight average molecular weight of the copolymer being 38,000) 3,000 parts by weight

2,4-Dichloro-6-hydroxy-s-triazine 23 parts by weight

Matting agent (polystyrene, average particle size of 2.4 μm) 1.5 parts by weight

<<Subbing layer coating solution "c-3">>

Latex of styrene/glycidyl methacrylate/butyl acrylate = 60/39/1 ternary system copolymer latex (Tg=75 °C) 6.2% (in terms of solid content)

styrene/glycidyl methacrylate/butyl acrylate = 20/40/40 ternary system copolymer latex 1.7%

Anionic surfactant S-1 0.1%

Water 92.0%

<<Subbing layer coating solution "d-3">>

| | |
|---|---|
| Gelatin | 1% |
| Anionic surfactant S-1 | 0.05% |
| Antifungal agent F-1 | 0.01% |
| Water | 98.9% |

<<Plasma treatment>>

The resulting subbed support was subjected to plasma treatment in the presence of a mixed gas of argon/nitrogen/hydrogen (90/5 % by volume) at a high frequency output power of 4.5 kW and at a frequency of 5 kHz for 5 seconds, employing a batch type atmospheric pressure plasma treatment apparatus AP-I-H340 (produced by Iishii Kagaku Co., Ltd.).

<<Heat treatment conditions>>

Each subbed support was slit to obtain a width of 1.25 m, and subjected to heat treatment (low tension heat treatment) at a tension of 2 hPa at 180 °C for one minute. «Preparation of silver halide emulsion A»

Employing a double-jet method, silver chlorobromide core grains comprised of 70 mole percent of silver chloride and 30 mole percent of silver bromide, which had an average diameter of 0.09 μm. The core grains were prepared by mixing an aqueous silver nitrate solution and an aqueous water-soluble halide solution in the presence of 7 x $10^{-8}$ mole of $K_3Rh(NO)_4(H_2O)_2$ and 8 x $10^{-6}$ mole of $K_3OsCl_6$ added, each based on 1 mol of silver to be added, while maintaining at a pH of 3.0, at a silver potential (EAg) of 165 mV, and at 40 °C. NaCl was added according to a double-jet method so that EAg was reduced to 125 mV to form a shell for the core grain. At this time, the halide solution containing 3 x $10^{-7}$ mole per mol of silver of $K_2IrCl_6$ and 9 x $10^{-8}$ mole per mole of silver of $K_3RhCl_6$ was employed. Further, KI conversion was processed with iodine employing fine silver iodide grains.

The thus obtained emulsion was a core/shell type monodispersed silver chlorobromoiodide (comprised of 85 mole percent of silver chloride, 0.1 mole percent of silver bromoiodide and the rest in silver bromide) emulsion (having a variation coefficient of 10 percent and a grain size with 0.2 μm in average diameter) and the silver chlorobromoiodide grains were cubic crystals having a [100] plane ratio of 87%. Subsequently, desalting was carried out employing modified gelatin such as exemplified compound G-8 described on page 287 (3) of Japanese Patent O.P.I. Publication No. 2-280139, which is described in JP O.P.I. No. 2-280139. The EAg after desalting was 190 mV at 50 °C.

A chemical sensitization employing chloroauric acid, inorganic sulfur, thiourea dioxide, and 2,3,4,5,6-pentafluorophenylphosphine selenide was conducted, and thereafter, to spectral sensitization employing sensitizing dye A.

Sensitizing dye A

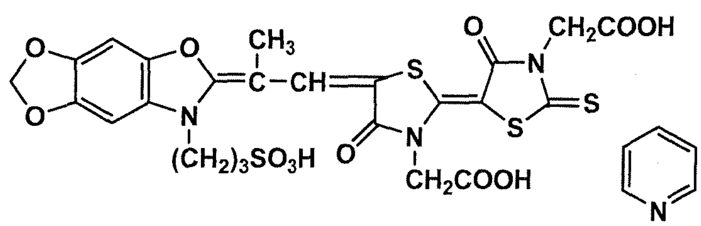

| (Preparation of coating solutions) | |
|---|---|
| <Hydrophilic layer coating solution> | |
| Gelatin | 21 parts |
| Silica particles with a particle size of 3 μm) | 9 parts |
| Carbon black dispersion solution (Solid content of 32% by weight) | 8 parts |
| Styrene-butadiene latex (POL 752A) (produced by Nippon A & L Co., Ltd.) | 2 parts |
| Surfactant Sodium dodecylbenzene sulfonate | 0.2 parts |
| Vinylsulfone (HD-2) | 2 parts |

Water was added to make a total amount of 400 parts, and pH of the solution was adjusted to 5. Additionally, a wet coating thickness is 40 g/$m^2$.

| <Silver halide emulsion layer coating solution> | |
|---|---|
| Silver halide emulsion A(silver nitrate/gelatin = 2/1 by weight) (in terms of silver nitrate) | 14 parts |
| 1-Phenyl-3-pyrazolidone | 1 part |
| Surfactant: Sodium dodecylbenzene sulfonate | 0.2 parts |

A total amount was adjusted to be 120 parts and pH of the solution was adjusted to 4.5. A wet coating thickness is 12 g/$m^2$.

| <Preparation of palladium sulfide sol> | |
|---|---|
| Solution A: Palladium chloride | 5 g |
| 12 mol/liter hydrochloric acid | 40 ml |
| Distilled water | 1000 ml |
| Solution B: Sodium sulfide | 8.6 g |
| Distilled water | 1000 ml |

The solutions A and B were mixed while stirring and the mixture was passed through ion-exchange resin in a column to obtain a palladium sulfide sol after 30 minutes.

| <Physical development nucleus layer coating solution> | |
|---|---|
| Palladium sulfide sol described above | 10 parts |
| Hydroquinone | 6 parts |
| 1-Phenyl-3-pyrazolidone | 0.4 parts |
| Copolymer of Acrylamide(97) and vinylimidazole(3) (Average molecular weight of 100,000) | 0.05 parts |
| Surfactant: Sodium dodecylbenzene sulfonate | 0.02 parts |
| Vinyl sulfone (HD-2) | 2 parts |

A total amount was adjusted to be 100 parts and pH of the solution was adjusted to 2.8. A wet coating thickness is 10 g/$m^2$.

| (Backing layer coating solution 1) | |
|---|---|
| Polymer latex (methyl methacrylate/styrene/ 2-ethyl hexylacrylate/2-hydroxyl ethylmethacrylate/ methacrylic acid = 59/9/26/5/1) (Tg=55 °C) (in terms of solid content) | 10 wt% |
| Water | 80 wt% |
| (Backing layer coating solution 2) | |
| Polymethyl methacrylate particles (spherical form an average particle size of 5 μm) (in terms of solid content) | 10 wt% |
| Polymer latex (LACSTAR 3307B) (produced by DAINIPPON INK AND CHEMICALS, INC. SBR latex: Tg=17 °C) (in terms of solid content) | 10 wt% |

(continued)

| | |
|---|---|
| (Backing layer coating solution 2) | |
| Water | 80 wt% |
| (Backing layer coating solution 3) | |
| Silica particles (SYLYLSIA-446) (in terms of solid content)<br>Polyfluorinated vinylidene (Tg=-39 °C) (in terms of solid content)<br>Water | 10 wt%<br>10 wt%<br>80 wt% |

[PREPARATION OF PLANOGRAPHIC PRINTING PLATE MATERIAL SAMPLES 101 THROUGH 104]

The backing layer coating solution obtained above was coated as shown in Table 1 on layer surface B of the subbed support, employing a slide-hopper coating method.
Materials 101 and 102 were dried under condition A, and materials 103 and 104 were dried under condition B.

The drying section was composed of five drying zones, a first drying zone through a fifth drying zone, each of which could control dwell time of the material at each zone, temperature, and humidity. The first drying zone was a cooling zone set at 0 °C, and used for setting. The second and third drying zones were constant rate drying zones, wherein the web in the drying zones was dried at an emulsion layer surface temperature of maximum 14 °C. Condition A: After the constant rate drying, the temperature of the web was elevated to 50 °C at the fourth drying zone, and to 55 °C at the fifth drying zone. The dwell time after the constant rate drying of the web at the zones was 15 seconds.
Condition B: After the constant rate drying, the temperature of the web was elevated to 30 °C at the fourth drying zone, and to 40 °C at the fifth drying zone. The dwell time after the constant rate drying of the web at the zones was 25 seconds.

The surface roughness Ra was measured. That of sample 101 was 0.08 µm, that of sample 102 10 µm, that of sample 103 2 µm, and that of sample 104 2 µm.

The hydrophilic layer coating solution and silver halide emulsion layer coating solution were simultaneously coated in that order in Table 1 on the subbing layer surface A of each of supports and dried, employing a slide-hopper coating method. The drying section was composed of five drying zones, a first drying zone through a fifth drying zone, each of which could control temperature and humidity. The first drying zone was a cooling zone set at 0 °C, and used for setting. The second and third drying zones were constant rate drying zones, wherein the web was dried at an emulsion layer surface temperature of maximum 14 °C. After the constant rate drying, the temperature of the web was elevated to 30 °C at the fourth drying zone, and to 50 °C at the fifth drying zone. The dwell time of the web at the fifth zone was 10 seconds. Subsequently, the physical development nucleus layer coating solution was coated on the silver halide emulsion layer employing a dip/wire bar squeeze method, and dried at a 30 °C hot air.

The planographic printing plate material was cut into a size of 73 cm (width) x 32 m (length), and wound around a spool made of cardboard having a diameter of 7.5 cm. Thus, a plate sample in roll form was prepared. The printing plate sample was wrapped in a 150 cm x 2 m package made of $Al_2O_3$PET (12µm)/Ny (15 µm)/CPP (70 µm) and heat-shielded at end faces from outside air. The wrapped sample was stored at 50 °C and 55% RH for 10 days for an accelerated aging test. The package had an oxygen permeation of 1.7 ml/atm·m$^2$·30°C·day, and a moisture permeability of 1.8 g/atm·m$^2$·25°C·day.

The specific resistance was measured. That of sample 101 and 102 was 5 x $10^{14}$ Ω, that of sample 103 10 µm, that of sample 103 5 x $10^{10}$ Ω, and that of sample 8 x $10^9$ Ω.
Meter: Teraohm Meter Model VE-30 produced by Kawaguchi Denki Co., Ltd.
Method: Immediately after the sample was stored at 23 °C and 20% RH for 24 hours, the specific resistance of a backing layer made of the printing plate material which prepared above was determined under the same conditions.

The section of the sample was observed employing an electron microscope, and the total thickness on the backing layer side was measured. As a result, that of sample 101 was 0.7 µm, that of sample 102 10 µm, that of sample 103 4 µm, that of sample 104 4 µm.

The surface roughness Ra on the backing layer side was measured by means of a non-contact type three dimension microscopic surface configuration measuring system RSTPLUS produced by WYKO Co., Ltd. As a result, that of sample 101 was 0.04 µm, that of sample 102 8 µm, that of sample 103 2 µm, that of sample 104 2 µm.

[Evaluation of planographic printing plate material samples 101 - 104]

(a) Image formation employing a red semiconductor laser]

The above sample was cut into a size for exposure and imagewise exposed employing Dolev 800V3. The

imagewise exposure was carried out employing 650 nm laser beams with a beam spot diameter of 18 μm to form an image with a screen number of 175 LPI at 2540 dpi. Herein, dpi represents the dot numbers per 2.54 cm. Subsequently, the exposed sample was processed employing an automatic developing machine COLORED PARTICLES-2865 (produced by MITSUBISHI SEISHI Co., Ltd. and DAINIPPON SCREEN SEIZO Co., Ltd.), wherein the sample was developed at 38 °C for 15 seconds, and dried at 45 °C.

Developers A, B and neutralization solution prepared as shown below were used.

| <Developer A> | |
|---|---|
| EDTA·2Na | 1 g |
| Potassium hydroxide | 20 g |
| Anhydrous sodium sulfite | 50 g |
| 2-Mercaptobenzoic acid | 1.5 g |
| 2-Aminoethyl-aminoethanol | 15 g |
| Oleophilic agent: 2-Mercapto-5-n-heptyloxidiazole | 0.25 g |
| Hydroxyphenylstearic acid(Trade name: Novazcid P, produced by Nippom Yushi Co., Ltd.) | 1 g |
| Water was added to make a 1 liter solution. | |
| <Neutralization and sensitization solution> | |
| Phosphoric acid | 1.2 g |
| Sodium primary phosphate | 25 g |
| Anhydrous sodium sulfite | 2.5 g |
| Ethylene glycol | 5 g |
| Oleophilic agent 2-Mercapto-5-n-heptyloxidiazole | 0.1 g |
| Diethanolamine | 5 g |

Water was added to make a 1 liter solution. pH of the solution was adjusted to 6.

The planographic printing plate samples 101 through 104 obtained by a developing process after exposure were evaluated as a printing plate according to the following printing method.

<<Printing method>>

Printing was carried out employing a printing press LITHRONE 26 produced by KOMORI CORPORATION. After notches for registering were punched in the planographic printing plate material and engaged with a pin of the printing press, printing was carried out employing the following dampening water, ink (Toyo King Hyecho M Magenta, produced by TOYO INK MANUFACTURING Co.) and coated paper sheets.

| <Dampening solution> | |
|---|---|
| Orthophosphoric acid | 10 g |
| Nickel nitrate | 5 g |
| Sodium nitrite | 5 g |
| Ethylene glycol | 100 g |
| Colloidal silica (20% solution) | 28 g |

Water is added to make a 1 liter solution.

<<Initial ink receptivity>>

Printing was started in the same way as in printing sequence in a conventional PS plate. The number of printing paper sheets printed from when printing started till when ink at non-image portions was completely eliminated was counted. The less the number, the higher the ink receptivity is.

<<Evaluation of registering property>>

On the shorter sides of the planographic printing plate material sample, two through-holes for setting an exposure standard and two notches for setting a standard on a printing press were punched. After the through-holes

were engaged with a pin of an exposure device, exposure was carried out employing the exposure device so that two cross-shaped line images with a width of 50 μm and a length of 2 cm, one being 50 cm distant from the other, were recorded. Thus, four exposed printing plate material samples were prepared. The notches of each of the four exposed samples were engaged with a pin of the printing press above. After they were mounted on the four plate cylinders of the printing press, printing was carried out in the same manner as above. But, four kinds of color ink such as soybean oil type TK Hyecho SOY1 ink, Yellow, Indigo, and Magenta were used for printing. Sampling was carried out for every 25 copies and no "out of color registration" on each color image of the cross-shaped line was measured for each printing copy. The Number of printing paper sheets which remain in the range of the value not more than 50 μm of "out of color registration" were calculated. The smaller value, the more excellent property is.

The number of paper sheets printed from when printing started till when 50% or more of dots of the 3% dot image were eliminated was counted and printing was carried out to obtain 20,000 copies. The more the number, the higher printing property is.

The results are shown in Table 1.

Table 1

| | Subbing layer coating solution | Backing layer coating | Initial ink receptivity (number) | Initial registering property (number of sheets) | Printing durability (number) | |
|---|---|---|---|---|---|---|
| 101 | c-3/d-3 | 1 | 200 or more | 200 | 1000 | comparison |
| 102 | c-3/d-3 | 3 | 200 or more | 200 | 1000 | comparison |
| 103 | c-1/d-1 | 2 | 5 | 50 | 20000 | the present invention |
| 104 | c-2/d-2 | 2 | 7 | 50 | 20000 | the present invention |

As is in Table 1, the printing result obtained by a printing plate made of the planographic printing plate material exhibits superior properties in all evaluation items to that of samples compared.

[EFFECT OF THE INVENTION]

The present invention can provide a planographic printing plate material providing excellent initial ink receptivity, excellent printing durability and greatly improved registering property, a printing plate prepared therefrom, and a printing method employing the printing plate.

## Claims

**1.** A planographic printing plate material comprising a plastic support having a hydrophilic layer on one surface and a backing layer on the other surface of the plastic support,
wherein the backing layer contains an organic matting agent and a polymer having a glass transition temperature (Tg) of -30 to 40 °C.

**2.** The planographic printing plate material of Claim 1,
wherein the backing layer has a specific resistance of 1 x $10^9$ to 2 x $10^{13}$ Ω.

**3.** The planographic printing plate material of Claim 1, further comprising a silver halide emulsion layer and a physical developing nucleus-containing layer on the hydrophilic layer.

**4.** The planographic printing plate material of Claim 2, further comprising the silver halide emulsion layer and the physical developing nucleus-containing layer on the hydrophilic layer.

**5.** The planographic printing plate material of Claim 1,
wherein the plastic support has an average thickness of 110 to 300 μm.

**6.** The planographic printing plate material of Claim 2,
wherein the plastic support has the average thickness of 110 to 300 µm.

**7.** The planographic printing plate material of Claim 3,
wherein the plastic support has the average thickness of 110 to 300 µm.

**8.** The planographic printing plate material of Claim 1,
wherein the planographic printing plate material is wound around a core having a diameter of 4 to 10 cm so as to form a roll.

**9.** The planographic printing plate material of Claim 2,
wherein the planographic printing plate material is wound around the core having a diameter of 4 to 10 cm so as to form a roll.

**10.** The planographic printing plate material of Claim 3,
wherein the planographic printing plate material is wound around the core having a diameter of 4 to 10 cm so as to form a roll.

**11.** The planographic printing plate material of Claim 5,
wherein the planographic printing plate material is wound around the core having a diameter of 4 to 10 cm so as to form a roll.

**12.** A printing plate obtained by imagewise exposing a surface of the hydrophilic layer of the planographic printing plate material of Claim 1 to laser beams based on image data and developing the exposured planographic printing plate material.

**13.** The printing plate obtained by imagewise exposing a surface of the hydrophilic layer of the planographic printing plate material of Claim 2 to laser beams based on image data and developing the exposed planographic printing plate material.

**14.** The printing plate obtained by imagewise exposing a surface of the hydrophilic layer of the planographic printing plate material of Claim 3 to laser beams based on image data and developing the exposed planographic printing plate material.

**15.** The printing plate obtained by imagewise exposing a surface of the hydrophilic layer of the planographic printing plate material of Claim 5 to laser beams based on image and developing the exposed planographic printing plate material.

**16.** The printing plate obtained by imagewise exposing a surface of the hydrophilic layer of the planographic printing plate material of Claim 8 to laser beams based on image data and developing the planographic printing plate material.

**17.** A printing method comprising the steps of:

providing a plurality of through-holes in the printing plate of any of claims 12 to 16; and
fixing the printing plate on a plate cylinder of a printing press, so that the through-holes coincide with a standard position for positioning.